# FASCICULE DE BREVET EUROPEEN

(11) **EP 1 845 565 B1**
(45) Date de publication et mention de la délivrance du brevet: **23.07.2008**
(21) Numéro de dépôt: 07354021.3
(22) Date de dépôt: 02.04.2007
(51) Int. Cl.: H01L 35/32, D03D 15/00

(54) **Structure thermoélectrique et utilisation de la structure thermoélectrique pour former une structure textile**
Thermoelektrischer Aufbau und Verwendung des thermoelektrischen Aufbaus zum Ausbilden eines textilen Flächengebildes
Thermoelectric structure and use of the thermoelectric structure to form a textile structure

(30) Priorité: 13.04.2006 FR 0603292
(43) Date de publication de la demande: 17.10.2007
(73) Titulaire: Commissariat à l'Energie Atomique, 75015 Paris (FR)
(72) Inventeur: Plissonnier, Marc, 38320 Eybens (FR); Salvi, Charles, 38000 Grenoble (FR); Lanier, Thierry, 38200 Vienne (FR); Coulaux, Denis, 69300 Caluire et Cuire (FR)
(74) Mandataire: Jouvray, Marie-Andrée

(56) Documents cités:
- WO-A-02/44676
- FR-A- 2 646 021
- JP-A- 2003 209 297
- US-A- 3 019 278
- US-A- 3 661 653
- US-A1- 2003 211 797
- YAMAMOTO N ET AL: "Electrical power generation from a knitted wire panel using the thermoelectric effect" ELECTRICAL ENGINEERING IN JAPAN SCRIPTA TECHNICA USA, vol. 140, no. 1, 15 juillet 2002 (2002-07-15), pages 16-21, XP002409291 ISSN: 0424-7760

## Description

### Domaine technique de l'invention

L'invention concerne une structure thermoélectrique constituée par un réseau de fils orientés sensiblement selon une direction de trame de la structure, comportant des premiers et deuxièmes fils conducteurs de natures différentes, entrelacés pour former des jonctions froides et chaudes réparties respectivement dans deux plans supérieur et inférieur, les jonctions étant alternativement froides et chaudes le long d'un même fil conducteur.

Elle concerne également l'utilisation d'une telle structure thermoélectrique pour former une structure textile.

### État de la technique

Ce type de structure thermoélectrique constitue un convertisseur thermoélectrique permettant, par exemple, de générer, grâce à l'effet Seebeck, une force électromotrice lorsqu'un gradient de température est appliqué entre les jonctions froides et chaudes. En particulier, lorsqu'une telle structure est intégrée au matériau de confection d'un vêtement, le gradient de température qui apparaît en service entre les milieux que sépare ledit matériau assure une production de courant susceptible d'alimenter des systèmes électroniques: Des vêtements de protection intégrant des systèmes de navigation, des capteurs ou des systèmes anti-contrefaçon, des prothèses qui permettent de renseigner sur l'état de l'articulation à protéger, des bandages de secours qui mesurent des paramètres physiques tels que le rythme cardiaque, peuvent être ainsi fabriqués sans intégration d'une source de puissance, grâce à une incorporation adaptée, lors de la fabrication, d'une telle structure thermoélectrique.

Ce type de structure thermoélectrique permet aussi de développer, grâce à l'effet Peltier, un gradient thermique lorsqu'un courant électrique est appliqué. Dans le domaine de la microélectronique, ce phénomène, par exemple, peut servir à améliorer les performances et la fiabilité des circuits intégrés grâce à un refroidissement contrôlé en temps réel.

A titre d'exemple, dans l'article « Electrical power generation from a knitted wire panel using thermoelectric effect » (© 2002 Wiley Periodicals, Inc. Electr Eng Jpn, 140(1) : 16-21), N. Yamamoto et H. Takai ont décrit une structure thermoélectrique constituant un générateur de puissance thermoélectrique. Cette structure se présente sous la forme d'un panneau de fils tricotés. Un substrat plan en résine époxy comporte des séries de trous alignés de manière à former des lignes parallèles. Les trous assurent la communication de part et d'autre du substrat. Des fils en alumel (alliage d'aluminium et de nickel) et en chromel (alliage de chrome et de nickel) sont insérés respectivement dans des lignes de trous adjacentes. Ces fils conducteurs sont donc globalement parallèles et passent successivement d'un côté et de l'autre du substrat. Sur chaque face du substrat, chaque fil conducteur forme une boucle entrelacée avec une boucle formée dans un fil conducteur adjacent. Plus précisément, un fil conducteur d'une espèce s'entrelace alternativement avec deux fils conducteurs différents de l'autre espèce, respectivement d'un côté et de l'autre du substrat. Ces croisements constituent des jonctions alternativement froides et chaudes réparties suivant deux plans superposés. Cette structure est ensuite rapportée sur la structure textile correspondante, par exemple par collage.

Ce type de structure thermoélectrique connu n'est cependant pas complètement satisfaisant. En effet, la fabrication de la structure thermoélectrique reste complexe et onéreuse, notamment à cause de la réalisation du substrat. Par ailleurs, les applications d'une telle structure thermoélectrique sont limitées par la souplesse du substrat, qui reste faible. Son intégration éventuelle dans une structure textile lors de la fabrication d'un produit destiné à la vente, nécessite des opérations supplémentaires qui ont pour conséquence d'accroître les coûts d'obtention du produit. D'autre part, le gradient thermique (qui est un facteur essentiel dans le rendement de la structure thermoélectrique) appliqué aux jonctions chaudes et froides n'est pas optimal, car la structure textile est interposée entre les jonctions et au moins l'un des milieux extérieurs recouvert par la structure textile. Par exemple, lorsque la structure textile dotée d'une telle structure thermoélectrique est appliquée à la fabrication d'un vêtement, les jonctions chaudes et le corps de l'utilisateur sont séparés par une épaisseur de structure textile, de même que les jonctions froides et l'extérieur si la structure thermoélectrique est disposée entre deux épaisseurs de textile.

### Objet de l'invention

L'invention a pour but de pallier aux inconvénients précédents en proposant une structure thermoélectrique dont la fabrication est facilitée et qui offre de meilleures caractéristiques de souplesse.

Selon l'invention, ce but est atteint par le fait que la structure thermoélectrique comporte, dans le plan supérieur, au moins un fil diélectrique haut et, dans le plan inférieur, au moins un fil diélectrique bas, les fils diélectriques étant entrelacés avec les premiers et deuxièmes fils conducteurs de façon à maintenir à distance les deux plans supérieur et inférieur.

Les fils diélectriques assurent la séparation des fils conducteurs et leur maintien en position au sein de la structure, de telle manière que les fils conducteurs ne s'entrelacent que dans les plans supérieur et inférieur. Les fils diélectriques remplissent donc une fonction d'isolation des jonctions chaudes et froides et permettent de s'affranchir de la nécessité du substrat. La structure thermoélectrique peut, de plus, être fabriquée en une seule opération de structuration des fils conducteurs et diélectriques.

Selon un développement de l'invention, dans la direction perpendiculaire à la direction de trame, deux jonctions froides adjacentes sont séparées et maintenues en position par une maille supérieure formée par un fil diélectrique haut, et deux jonctions chaudes adjacentes sont séparées et maintenues en position par une maille inférieure formée par un fil diélectrique bas.

D'autre part, une structure thermoélectrique selon l'invention peut être utilisée pour former une structure textile, les fils diélectriques étant alors constitués par des fibres textiles. La fabrication d'une structure textile intégrant une structure thermoélectrique est donc largement facilitée par rapport à l'art antérieur, car elle est réalisée en une seule opération où les fibres textiles et les fils conducteurs sont directement et simultanément structurés ensemble, par exemple par tricotage. De plus, le rendement de la structure thermoélectrique incorporée est largement amélioré car le gradient de température appliqué aux jonctions froides et chaudes correspond au gradient de température entre les milieux extérieurs séparés par la structure textile.

### Description sommaire des dessins

D'autres avantages et caractéristiques ressortiront plus clairement de la description qui va suivre d'un mode particulier de réalisation de l'invention donné à titre d'exemple non limitatif et représenté sur la planche unique annexée, représentant schématiquement un exemple de réalisation de structure thermoélectrique selon l'invention.

### Description d'un mode particulier de réalisation

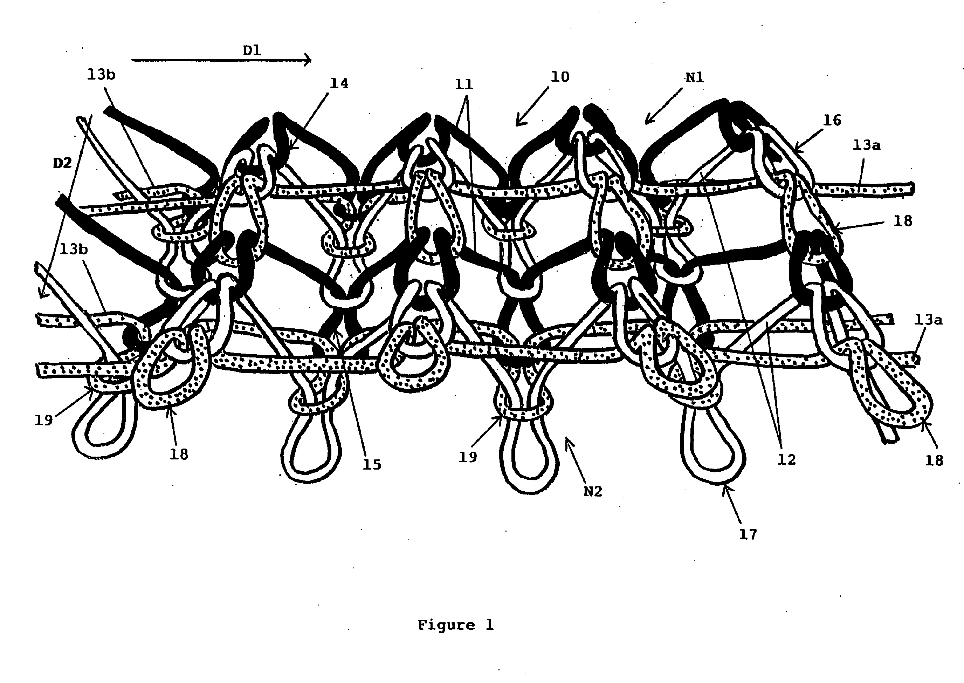

La figure 1 illustre une bande d'un exemple de réalisation d'une structure thermoélectrique 10 selon l'invention. La structure thermoélectrique 10 est réalisée, dans l'exemple, par un tricotage de type Jacquard. Elle combine des premiers et deuxièmes fils conducteurs 11 et 12 de natures différentes, respectivement représentés en noir et en blanc, et des fils diélectriques haut 13a et bas 13b réalisés dans une matière isolante électriquement et représentés par des pointillés. Pour le tricotage, deux bobines de fils diélectriques 13a et 13b et deux bobines de fils conducteurs 11 et 12 de natures différentes alimentent simultanément les aiguilles d'un métier à tricoter adapté pour la réalisation de la structure thermoélectrique 10 qui sera décrite ci-après. Le procédé de tricotage est bien connu en soi et ses modalités peuvent être facilement déterminées à la seule lumière de la structure à réaliser. Le procédé de tricotage ne sera donc pas décrit en détail dans le cadre de la présente description.

Les fils conducteurs 11, 12 et les fils diélectriques 13a, 13b constituent un réseau de fils sensiblement parallèles, entrelacés, qui s'étendent sensiblement selon une direction de trame D1 de la structure 10. La direction de la structure 10 orthogonale à la direction de trame D1, correspond à la direction de tricotage nommée D2. Plus précisément, la structure thermoélectrique 10 est formée de deux nappes N1, N2 superposées, respectivement supérieure et inférieure, dont chacune est constituée de rangs de mailles, orientés selon la direction de trame D1. La liaison entre les faces en regard des deux nappes N1 et N2 est réalisée par les fils conducteurs 11, 12 qui forment eux-mêmes des rangs de mailles constituant, avec les fils diélectriques associés, les nappes N1, N2.

Dans chaque nappe N1 et N2, chaque fil conducteur 11 forme un rang de mailles selon la direction D1, respectivement référencées 14 et 15, constituées chacune par une boucle en forme de U. De même pour les fils conducteurs 12, chacun d'entre eux forme un rang de mailles dans chaque nappe, respectivement référencées 16, 17 pour les nappes N1 et N2. Dans la direction de trame D1, chaque fil conducteur 11 forme alternativement des mailles inférieures 15 et des mailles supérieures 14, la liaison entre une maille supérieure 14 et une maille inférieure 15 adjacente assurant la liaison entre les nappes N1 et N2. De manière analogue, dans la direction de trame D1, chaque fil conducteur 12 forme alternativement des mailles inférieures 17 et des mailles supérieures 16, la liaison entre une maille supérieure 16 et une maille inférieure 17 adjacente assurant la liaison entre les nappes N1 et N2.

Chaque fil diélectrique 13a, appelé fil diélectrique haut, s'étend uniquement dans la nappe supérieure N1, sensiblement parallèlement aux fils conducteurs 11, 12, et forme un rang de mailles supérieures 18 appartenant toutes à la nappe supérieure N1. De manière analogue, chaque fil diélectrique 13b, appelé fil diélectrique bas, s'étend uniquement dans la nappe inférieure N2, parallèlement aux fils conducteurs 11, 12, et forme un rang de mailles inférieures 19 appartenant toutes à la nappe inférieure N2.

Comme représenté sur la figure, des rangs de mailles successifs sont formés suivant la direction D2. En effet, dans la direction de trame D1, chaque premier fil conducteur 11 vient s'insérer alternativement dans la nappe supérieure N1 dans une maille supérieure 18 formée par un fil diélectrique haut 13a et dans la nappe inférieure N2 dans une maille inférieure 17 adjacente formée par un deuxième fil conducteur 12. A partir de chaque maille supérieure 18 et inférieure 17, le fil conducteur 11 mentionné ci-dessus forme lui-même des mailles, respectivement supérieure 14 et inférieure 15. Puis, toujours dans la direction de trame D1, un fil diélectrique bas 13b vient s'insérer dans les mailles inférieures 15 formées par le fil conducteur 11 ci-dessus, pour former lui-même les mailles inférieures 19 d'un rang inférieur suivant. Dans la direction de trame D1, un deuxième fil conducteur 12 vient s'insérer alternativement dans la nappe supérieure N1, dans une maille supérieure 14 formée par le premier fil conducteur 11 mentionné ci-dessus, et dans la nappe inférieure N2 dans une maille inférieure 19 formée par le fil diélectrique bas 13b précédent. A partir de chaque maille supérieure 14 et inférieure 19, le fil conducteur 12 forme lui-même des mailles, respectivement supérieure 16 et inférieure 17. Puis toujours dans la direction de trame D1, un fil diélectrique haut 13a vient s'insérer dans les mailles supérieures 16 formées par le fil conducteur 12 précédent, pour former lui-même les mailles supérieures 18 d'un rang supérieur suivant.

Ainsi, dans ce mode de réalisation, deux fils diélectriques 13a, 13b et deux fils conducteurs 11, 12 adjacents constituent un motif générique se répétant dans la direction D2 de la structure. Dans ce motif générique, le premier fil conducteur 11 s'entrelace, dans la direction de trame D1, alternativement avec deux deuxièmes fils conducteurs 12 différents, respectivement dans le rang suivant de la nappe supérieure N1 et dans le rang précédent de la nappe inférieure N2. De manière analogue, le deuxième fil conducteur 12 s'entrelace, dans la direction de trame D1, alternativement avec deux premiers fils conducteurs 11 différents, respectivement dans le rang précédent de la nappe supérieure N1 et dans le rang suivant de la nappe inférieure N2.

Ces entrelacements constituent des jonctions alternativement froides et chaudes, réparties suivant deux plans superposés matérialisés par les nappes supérieure N1 et inférieure N2. Par conséquent, dans la direction D2, deux jonctions froides adjacentes sont séparées et maintenues en position par une maille supérieure 18 formée par un fil diélectrique haut 13a, et deux jonctions chaudes adjacentes sont séparées et maintenues en position par une maille inférieure 19 formée par un fil diélectrique bas 13b. Les fils diélectriques 13a, 13b assurent donc la séparation des fils conducteurs 11 et 12, leur support et leur maintien en position au sein de la structure 10, de telle manière que les fils conducteurs 11 et 12 ne s'entrelacent que dans les plans supérieur et inférieur. Les fils diélectriques 13a, 13b maintiennent ainsi à distance les plans supérieur et inférieur, remplissent aussi une fonction d'isolation électrique des jonctions chaudes entre elles et froides entre elles, et participent à la réalisation d'une structure thermoélectrique 10 tridimensionnelle. D'autre part, la structure thermoélectrique 10 peut être fabriquée en une seule opération de structuration des fils conducteurs 11, 12 et diélectriques 13a, 13b, ici par tricotage.

Les fils diélectriques 13a, 13b assurent, de plus, une grande souplesse à la structure thermoélectrique 10. Tout autre moyen adapté d'insertion des fils diélectriques 13a, 13b dans les plans supérieur et inférieur peut être envisagé, dès lors qu'ils remplissent les fonctions évoquées précédemment. Par exemple, les fils diélectriques peuvent être agencés suivant la direction D2. De même, la structure thermoélectrique 10 peut être fabriquée avec d'autres procédés de fabrication, comme par exemple le tissage, la forme des entrelacements et des jonctions étant adaptés en conséquence.

Les jonctions alternativement froides et chaudes le long d'un même fil conducteur 11, 12, sont en série le long d'un même rang de mailles. Suivant la manière de raccorder les rangs de mailles entre eux, les jonctions constituent des thermocouples thermiquement en parallèle et qui peuvent être électriquement en série ou en parallèle.

De manière avantageuse, les fils diélectriques 13a 13b peuvent être constitués par des fibres textiles, comme par exemple du coton, du lin, de la soie, ou des fibres textiles synthétiques. La structure thermoélectrique 10 est alors utilisée pour former une structure textile tridimensionnelle. Plus précisément, la structure thermoélectrique 10 est totalement incorporée dans la structure textile et participe à sa structuration. La structure thermoélectrique 10 peut être agencée sur la totalité de la structure textile ou uniquement sur une partie de celle-ci. Bien entendu, on choisit le nombre de fils conducteurs, et donc de jonctions, leur densité ainsi que leur matière, en fonction de la qualité finale de la structure textile en terme de thermoélectricité. La surface de la structure thermoélectrique 10 pouvant être très grande, l'énergie collectée peut être significative même si les fils conducteurs 11, 12 n'ont pas de propriétés thermoélectriques élevées.

A titre d'exemple, un prototype tricoté correspondant à une ceinture de 1 m de long et de 4,5 cm de large comprenant 3366 jonctions par face, a permis d'obtenir une puissance électrique de 285 µW sous une tension de 80 mV lorsqu'un gradient thermique de 30°C est appliqué aux jonctions froides et chaudes.

Enfin, les fils diélectriques 13a, 13b, en maintenant et en étirant la structure, établissent les contacts entre les fils conducteurs 11, 12 pour constituer simplement les jonctions. On peut aussi les souder l'un à l'autre au niveau des jonctions, par exemple par effet Joule en faisant passer un courant dans les fils conducteurs 11, 12 ou en créant un arc électrique.

La technique du guipage peut être utilisée lors de la fabrication de la structure thermoélectrique 10. Son intérêt est de permettre le tricotage suivant des cadences élevées sans risque de casse des fils conducteurs 11, 12. Par ailleurs, la dissolution ou la fusion du fil de guipage permet d'obtenir une dilatation de la structure 10. Lorsque cette dernière est incorporée dans une structure textile, cette dilatation améliore les caractéristiques d'isolation de la structure textile grâce à un accroissement de la densité des fils et les caractéristiques de la structure thermoélectrique grâce à une mise sous tension des jonctions froides et chaudes. Dans ce cas, il n'est pas nécessaire de souder les fils conducteurs 11, 12 au niveau des jonctions.

## Revendications

1. Structure thermoélectrique (10) constituée par un réseau de fils (11, 12, 13a, 13b) orientés sensiblement selon une direction de trame (D1) de la structure (10), comportant des premiers (11) et deuxièmes (12) fils conducteurs de natures différentes, entrelacés pour former des jonctions froides et chaudes réparties respectivement dans deux plans supérieur et inférieur, les jonctions étant alternativement froides et chaudes le long d'un même fil conducteur (11, 12), structure **caractérisée en ce qu'**elle comporte, dans le plan supérieur, au moins un fil diélectrique haut (13a) et, dans le plan inférieur, au moins un fil diélectrique bas (13b), les fils diélectriques (13a, 13b) étant entrelacés avec les premiers (11) et deuxièmes (12) fils conducteurs de façon à maintenir à distance les deux plans supérieur et inférieur.

2. Structure selon la revendication 1, **caractérisée en ce que** les fils diélectriques (13a, 13b) sont orientés sensiblement selon la direction de trame (D1).

3. Structure selon l'une des revendications 1 ou 2, **caractérisée en ce que** les fils diélectriques (13a, 13b) et les fils conducteurs (11, 12) constituent un motif générique se répétant dans une direction (D2) de la structure (10) perpendiculaire à la direction de trame (D1).

4. Structure selon l'une des revendications 1 à 3, **caractérisée en ce qu'**elle est réalisée par tricotage de type Jacquard.

5. Structure selon la revendication 4, **caractérisée en ce que**, dans la direction (D2) perpendiculaire à la direction de trame (D1), deux jonctions froides adjacentes sont séparées et maintenues en position par une maille supérieure (18) formée par un fil diélectrique haut (13a), et deux jonctions chaudes adjacentes sont séparées et maintenues en position par une maille inférieure (19) formée par un fil diélectrique bas (13b).

6. Structure selon l'une des revendications 4 et 5, **caractérisée en ce que**, dans la direction de trame (D1), un fil conducteur (11, 12) d'une nature s'entrelace alternativement avec deux fils conducteurs (11, 12) distincts de l'autre nature, respectivement dans les plans supérieur et inférieur.

7. Structure selon l'une des revendications 4 à 6, **caractérisée en ce que**, dans la direction de trame (D1), chaque premier fil conducteur (11) vient s'insérer alternativement dans le plan supérieur dans une maille supérieure (18) formée par un fil diélectrique haut (13a) et dans le plan inférieur dans une maille inférieure (17) formée par un deuxième fil conducteur (12), et chaque deuxième fil conducteur (12) vient s'insérer alternativement dans le plan supérieur dans une maille supérieure (15) formée par un premier fil conducteur (11) et dans le plan inférieur dans une maille inférieure (19) formée par un fil diélectrique bas (13b).

8. Utilisation de la structure thermoélectrique (10) selon l'une des revendications 1 à 7 pour former une structure textile, **caractérisée en ce que** les fils diélectriques (13a, 13b) sont constitués par des fibres textiles.

## Claims

1. Thermoelectric structure (10) formed by a network of wires (11, 12, 13a, 13b) oriented substantially in a weft direction (D1) of the structure (10), comprising first (11) and second (12) conducting wires of different natures that are interwoven to form cold and hot junctions distributed respectively in two planes, a top plane and a bottom plane, the junctions being alternately cold and hot along any one conducting wire (11, 12), structure **characterized in that** it comprises at least one high dielectric wire (13a), in the top plane, and at least one low dielectric wire (13b), in the bottom plane, the dielectric wires (13a, 13b) being interwoven with the first (11) and second (12) conducting wires so as to keep the top and bottom planes at a distance from one another.

2. Structure according to claim 1, **characterized in that** the dielectric wires (13a, 13b) are oriented substantially in the weft direction (D1).

3. Structure according to one of the claims 1 or 2, **characterized in that** the dielectric wires (13a, 13b) and the conducting wires (11, 12) form a generic pattern that is repeated in a direction (D2) of the structure (10) perpendicular to the weft direction (D1).

4. Structure according to one of the claims 1 to 3, **characterized in that** it is produced by Jacquard knitting.

5. Structure according to claim 4, **characterized in that**, in the direction (D2) perpendicular to the weft direction (D1), two adjacent cold junctions are separated and kept in position by a top stitch (18) formed by a high dielectric wire (13a), and two adjacent hot junctions are separated and kept in position by a bottom stitch (19) formed by a low dielectric wire (13b).

6. Structure according to one of the claims 4 and 5, **characterized in that**, in the weft direction (D1), a conducting wire (11, 12) of one nature is interwoven alternately with two distinct conducting wires (11, 12) of the other nature, respectively in the top and bottom planes.

7. Structure according to one of the claims 4 to 6, **characterized in that**, in the weft direction (D1), each first conducting wire (11) is inserted alternately in the top plane in a top stitch (18) formed by a high dielectric wire (13a) and in the bottom plane in a bottom stitch (17) formed by a second conducting wire (12), and each second conducting wire (12) is inserted alternately in the top plane in a top stitch (15) formed by a first conducting wire (11) and in the bottom plane in a bottom stitch (19) formed by a low dielectric wire (13b).

8. Use of the thermoelectric structure (10) according to one of the claims 1 to 7 to form a textile structure, **characterized in that** the dielectric wires (13a, 13b) are formed by textile fibers.

## Patentansprüche

1. Thermoelektrisches Gewirk (10), das aus einem Netz aus Fäden (11, 12, 13a, 13b) besteht, die im Wesentlichen in einer Schussrichtung (D1) des Gewirks (10) ausgerichtet sind, und erste (11) und zweite (12) leitende Fäden unterschiedlicher Beschaffenheit umfasst, die miteinander verflochten sind, um kalte und warme Verbindungsstellen zu bilden, die jeweils auf zwei Ebenen, einer oberen und einer unteren, verteilt sind, wobei die Verbindungsstellen entlang ein und desselben leitenden Fadens (11, 12) abwechselnd kalt und warm sind, Gewirk, das **dadurch gekennzeichnet ist, dass** es auf der oberen Ebene mindestens einen oberen dielektrischen Faden (13a) und auf der unteren Ebene mindestens einen unteren dielektrischen Faden (13b) umfasst, wobei die dielektrischen Fäden (13a, 13b) mit den ersten (11) und zweiten leitenden Fäden (12) so verflochten sind, dass sie die obere und die untere Ebene voneinander in Abstand halten.

2. Gewirk nach Anspruch 1, **dadurch gekennzeichnet, dass** die dielektrischen Fäden (13a, 13b) im Wesentlichen in Schussrichtung (D1) ausgerichtet sind.

3. Gewirk nach einem der Ansprüche 1 oder 2, **dadurch gekennzeichnet, dass** die dielektrischen Fäden (13a, 13b) und die leitenden Fäden (11,12) ein generisches Muster bilden, das sich in einer zur Schussrichtung (D1) senkrechten Richtung (D2) des Gewirks (10) wiederholt.

4. Gewirk nach einem der Ansprüche 1 bis 3, **dadurch gekennzeichnet, dass** es in Jacquardtechnik gestrickt ist.

5. Gewirk nach Anspruch 4, **dadurch gekennzeichnet, dass** in Querrichtung (D2) zur Schussrichtung (D1) zwei aneinander grenzende kalte Verbindungsstellen getrennt sind und in Position gehalten werden von einer oberen Masche (18), die von einem oberen dielektrischen Faden (13a) gebildet wird, und zwei aneinander grenzende warme Verbindungsstellen getrennt sind und in Position gehalten werden von einer unteren Masche (19), die von einem unteren dielektrischen Faden (13b) gebildet wird.

6. Gewirk nach einem der Ansprüche 4 und 5, **dadurch gekennzeichnet, dass** in Schussrichtung (D1) ein leitender Faden (11, 12) einer Beschaffenheit abwechselnd mit zwei gesonderten leitenden Fäden der anderen Beschaffenheit (11, 12) verwoben ist, und zwar jeweils auf der oberen und der unteren Ebene.

7. Gewirk nach einem der Ansprüche 4 bis 6, **dadurch gekennzeichnet, dass** in Schussrichtung (D1) jeder erste leitende Faden (11) auf der oberen Ebene abwechselnd in eine obere Masche (18) eingeführt ist, die von einem oberen dielektrischen Faden (13a) gebildet wird, und auf der unteren Ebene in eine untere Masche (17), die von einem zweiten leitenden Faden (12) gebildet wird, und dass jeder zweite leitende Faden (12) abwechselnd auf der oberen Ebene in eine obere Masche (15) eingeführt ist, die von einem ersten leitenden Faden (11) gebildet wird, und auf der unteren Ebene in eine untere Masche (19), die von einem unteren dielektrischen Faden (13b) gebildet wird.

8. Verwendung des thermoelektrischen Gewirks (10) nach einem der Ansprüche 1 bis 7 zur Herstellung eines textilen Gewirks, **dadurch gekennzeichnet, dass** die dielektrischen Fäden (13a, 13b) von Textilfasern gebildet werden.
